# EUROPEAN PATENT APPLICATION

(11) **EP 0 820 146 A2**
(43) Date of publication of application: **21.01.1998**
(21) Application number: 97111053.1
(22) Date of filing: 02.07.1997
(51) Int. Cl.: H03K 3/356, H03K 3/0231, H03L 7/099

(54) **Differential delay element to prevent common mode oscillation and input hysteresis**

(30) Priority: 16.07.1996 US 682025
(71) Applicant: SEIKO EPSON CORPORATION, Tokyo 163 (JP)
(72) Inventor: Rogers, Robert, Liberty, Missouri 64068 (US); Chi, Kuang Kai, San Jose, California 95129 (US); Chen, Jason C., San Jose, California 95129 (US); Fujimori, Keitaro, Suwa-gun, Nagano (JP); Furuya, Yasunari, Chino-shi, Nagano (JP); Kasahara, Shoichiro, Suwa-shi, Nagano (JP); Kikuhara, Kazumichi, Chino-shi, Nagano (JP)
(74) Representative: Grünecker, Kinkeldey, Stockmair & Schwanhäusser Anwaltssozietät

(57) **Abstract**

A system for providing a differential delay element which optimize the prevention of both common mode oscillation and input hysteresis. The system includes a first voltage supply terminal, a second voltage supply terminal and a current-regulating voltage terminal. The system further includes a current-control MOS transistor having its source connected to the first voltage supply terminal and its gate connected to the current-regulating voltage terminal. A pair of inverters are connected to the current-control MOS transistor. Each inverter has an input MOS transistor with its source connected to the drain of the current-control transistor and its gate forming a respective input terminal, and a load MOS transistor with its drain coupled to the drain of the input transistor and forming an output terminal, and its source connected to the second voltage supply terminal. The system still further includes a pair of cross-coupling means to prevent common mode oscillation, each connecting the gate of the load transistor of a respective inverter and the output terminal of the other inverter to form a positive feedback. A pair of MOS diodes are coupled to the load transistors to prevent input hysteresis characteristics. Each diode is coupled between the drain and the source of a respective load transistor. To prevent both common mode oscillation and input hysteresis, the channel sizes of the diodes substantially equal the channel sizes of the load transistors.

## Description

### BACKGROUND OF THE INVENTION

### 1. Field of the Invention

This invention relates generally to voltage-controlled oscillators, and more particularly to a differential delay element using a symmetrical cross-coupled non-hysteresis load for preventing common mode oscillation in a voltage-controlled oscillator.

### 2. Description of the Background Art

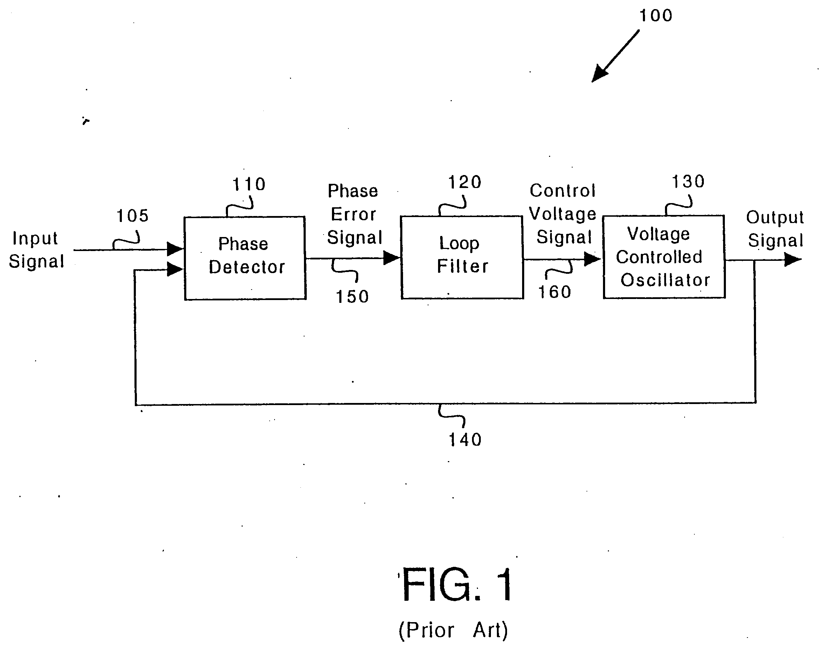

FIG. 1 illustrates a traditional phase-locked loop 100, including a phase detector 110 connected to a loop filter 120 which is in turn connected to a voltage-controlled oscillator (VCO) 130. The output of VCO 130 is fed back to phase detector 110. Phase detector 110 compares the phase of an input signal on line 105 with the frequency of the output signal on line 140 from voltage-controlled oscillator 130, and generates a phase error signal on line 150 corresponding to the difference. Loop filter 120 filters the phase error signal on line 150 and applies a control voltage signal on line 160 to voltage-controlled oscillator 130 for controlling the frequency of operation of the VCO. Because of the feedback system, VCO 130 can convert the control voltage signal on line 160 to an output signal on line 140 having a fixed frequency which is phase locked with the input signal.

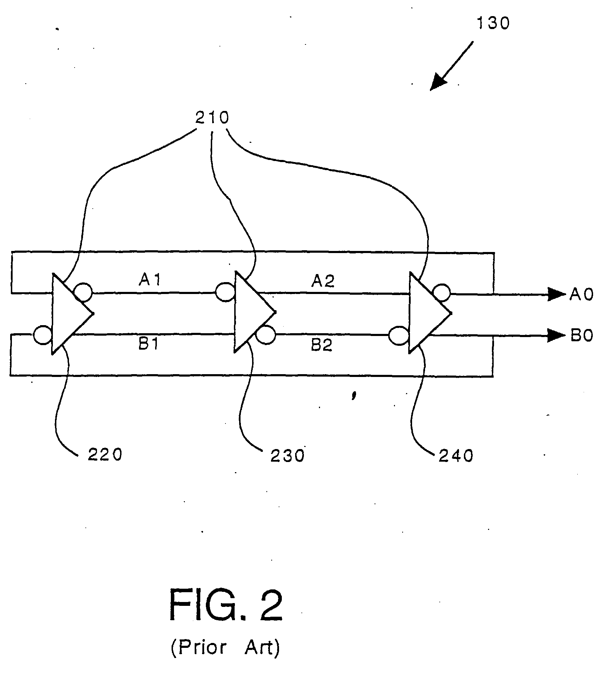

The most critical element of phase-locked loop 100 is voltage-controlled oscillator 130. FIG. 2 illustrates a typical voltage-controlled oscillator 130, which includes a multi-stage ring of voltage-controlled differential delay elements (VCDDE) 210 fabricated using complementary-metal-oxide-semiconductor (CMOS) technology. Each VCDDE 210 has a representative pair of preferably complementary differential inputs and outputs A0/B0, A1/B1, A2/B2, and may oscillate in differential mode and in common mode.

In differential mode, a first VCDDE 220 receives the differential pair A0/B0, and inverts and forwards it as the differential pair A1/B1 to a second VCDDE 230. VCDDE 230 inverts the pair A1/B1 and forwards it as the differential pair A2/B2 to a third VCDDE 240. Lastly, VCDDE 240 inverts the pair A2/B2 and forwards it as differential pair A0/B0 back to VCDDE 220. Ideally, differential pairs A0/B0, A1/B1 and A2/B2 each have a 180 degree phase shift between themselves. Because VCDDEs 210 operating in common mode, i.e. wherein each A/B pair are in phase with each other, suffer from reduced speed, instability and substandard noise rejection characteristics, VCDDEs 210 operating in differential mode are more desirable.

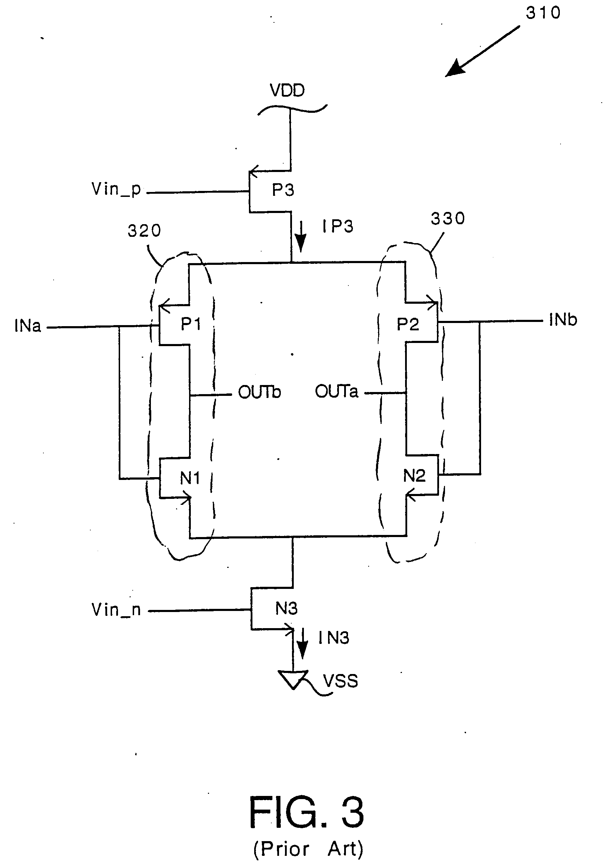

FIG. 3 illustrates a first example of a prior art VCDDE 310 as described in U.S. Patent Number 5,239,274 entitled "Voltage-Controlled Ring Oscillator Using Complementary Differential Buffers for Generating Multiple Phase Signals." VCDDE 310 includes a sourcing PMOS transistor P3 connected to a voltage source VDD and controlled by a voltage control signal Vin₋P, and an NMOS sinking transistor N3 connected to a ground voltage source VSS and controlled by a voltage control signal Vin_n. Two parallel inverters 320 and 330 are connected between sourcing transistor P3 and sinking transistor N3. Inverter 320 includes a PMOS transistor P1 connected to an NMOS transistor N1. Inverter 330 includes a PMOS transistor P2 connected to an NMOS transistor N2.

Control signals Vin_p and Vin_n cause equal currents IP3 and IN3 through transistors P3 and N3 respectively, and thus regulate the effective oscillating speed of VCDDE 310. Further, inverters 320 and 330 receive input signals INa and INb respectively for regulating output voltages OUTa and OUTb. When input voltage INa is high and input voltage INb is low, transistor N1 is conducting and transistor P1 is nonconducting, thereby pulling output voltage OUTa low. Further, transistor P2 is conducting and transistor N2 is nonconducting, thereby pulling output voltage OUTb high. Similarly, when Input voltage INa is low and input voltage INb is high, transistor P1 is conducting and transistor N1 is nonconducting thereby pulling output voltage OUTa high, and transistor N2 is conducting and transistor P2 is nonconducting thereby pulling output voltage OUTb low. At low input voltages which produce low sourcing currents IP3 and IN3, VCDDE 310 suffers the problem of common mode oscillation, instead of the desired differential mode oscillation. If input voltage INa equals input voltage INb, then, since there is no mechanism to prevent common mode oscillations, output voltage OUTa equals output voltage OUTb.

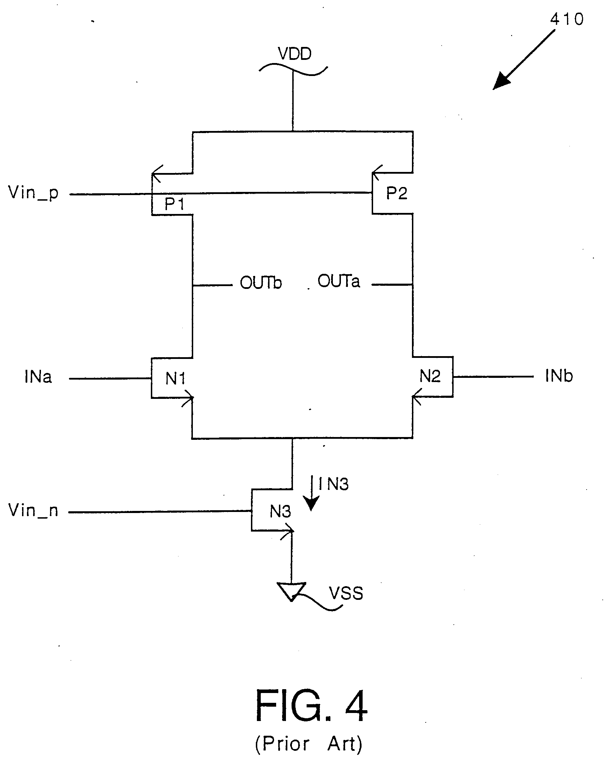

FIG. 4 illustrates a second exemplary VCDDE 410 as described in an article entitled "A 30-MHz Hybrid Analog/Digital Clock Recovery Circuit in 2µm CMOS," by Kim, Helman and Gray, published in the Journal of Solid-State Circuits, Volume 25, Number 6, December 1990, page 1385. VCDDE 410 includes a PMOS transistor P1 connected to a supply voltage source VDD and to an NMOS transistor N1 coupled in parallel with a PMOS transistor P2 connected to the supply voltage source VDD and to an NMOS transistor N2. Transistors N1 and N2 are each connected to a sinking NMOS transistor N3, which is connected to a ground voltage source VSS.

An input control voltage Vin_p is applied to the gates of transistor P1 and of transistor P2 to make them operate similarly to resistors. An input control voltage Vin_n is applied to the gate of transistor N3 to control the current IN3. As described with reference to FIG. 3, input voltage INa controls output voltage OUTb and input voltage INb controls output voltage OUTa. However, VCDDE 410 has no mechanism to prevent common mode oscillation. Thus, if input voltages INa and INb are equal, then output voltages OUTa and OUTb will be equal.

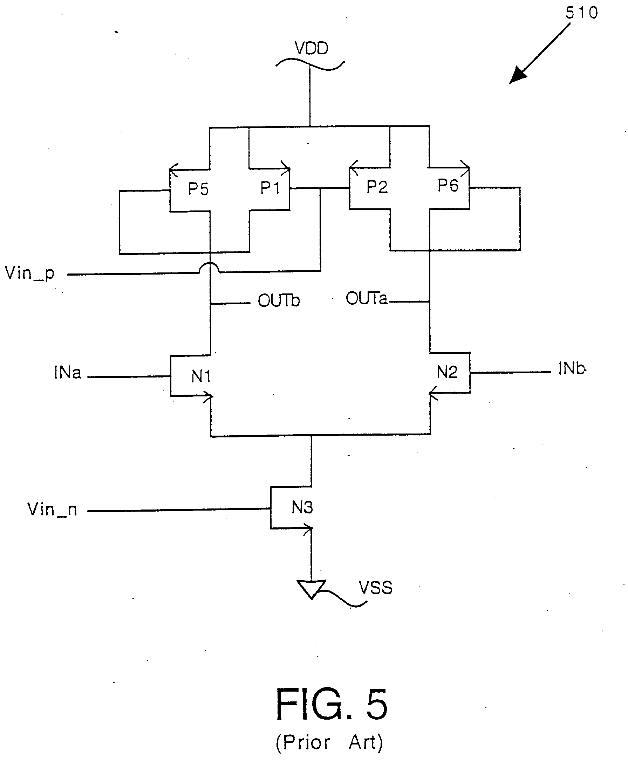

FIG. 5 illustrates another prior art VCDDE 510, as described in the proceedings of the IEEE International Solid-State Circuits Conference, December 1990, page 1385. VCDDE 510 is constructed similarly to VCDDE 410, and further includes a PMOS transistor P5 connected in parallel with transistor P1 and a PMOS transistor P6 connected in parallel with transistor P2, each transistor having its gate coupled to its drain. Transistors P5 and P6 operate as diodes to clamp the DC low values of output voltage OUTa and of output voltage OUTb to one PMOS diode drop from supply voltage VDD. Using diode clamps, VCDDE 510 achieves better DC stability and better, but not total, common mode rejection.

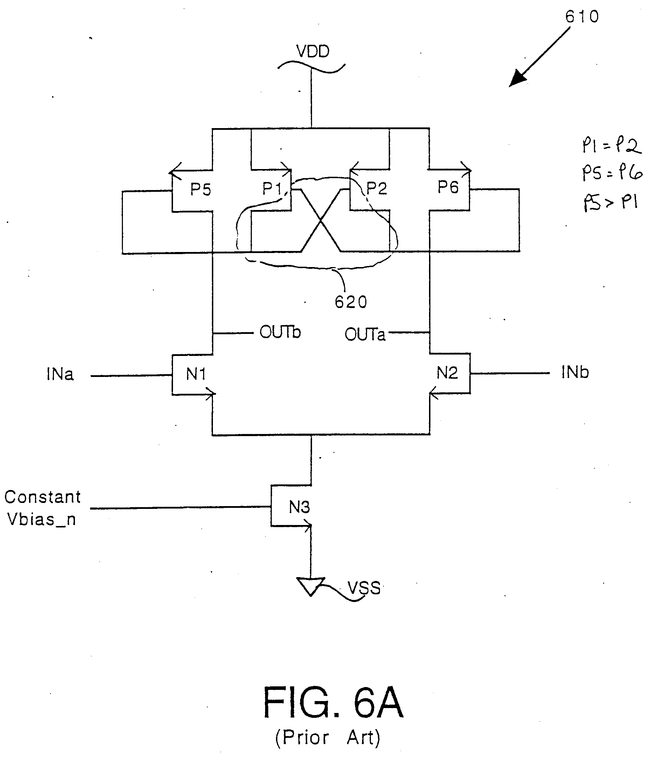

FIG. 6A illustrates a conventional CMOS comparator 610 as described in the IEEE Journal of Solid-State Circuits, February 1979, page 38. Comparator 610 is constructed similarly to VCDDE 510, except comparator 610 uses a cross-coupled load 620 instead of input control voltage Vin_p and for fixing the operating speed applies a constant DC voltage Vbias_n, which is between supply voltage VDD and ground voltage VSS, to the gate of transistor N3 instead of input control voltage Vin_n. Cross-coupled load 620 achieves positive feedback between differential outputs OUTa and OUTb, and thus can prevent common mode operation. However, to increase gain and to avoid input hysteresis characteristics, comparator 610 uses transistor P1 and transistor P2 of equal size (channel width and length), and transistor P5 and transistor P6 of equal size, and transistors P5 and P6 of larger size than transistors P1 and P2.

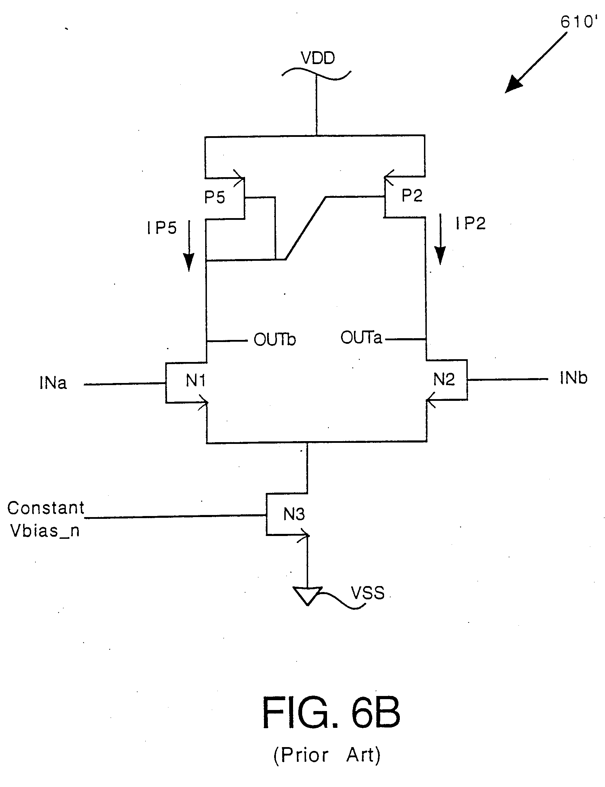

Transistors P5 and P6 provide a mechanism for preventing input hysteresis. For example, if transistors P5 and P6 are each smaller than transistors P1 and P2, and if as illustrated in half-circuit 610' of FIG. 6B input voltage INa is set to a bias voltage B, input voltage INb is low, output voltage OUTa is high and output voltage OUTb is low, then transistors N1 and P2 are conducting and transistors P1 and N2 are nonconducting. As input voltage INb increases, transistor N2 begins to conduct current. When the current through transistor N2 equals the current through transistor P2, the circuit 610 begins to change state.

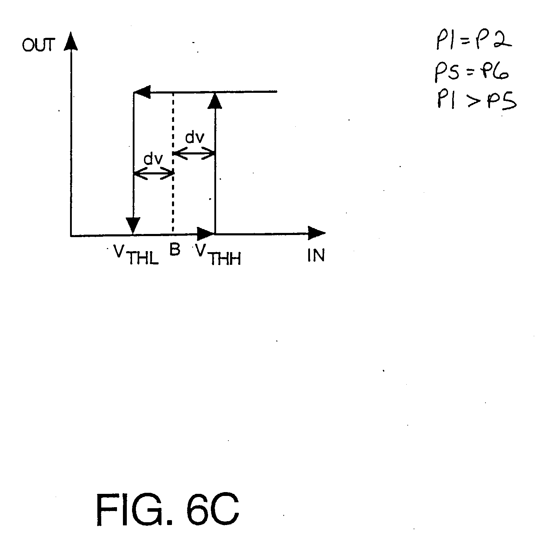

Since transistor P5 is smaller than transistor P2, the current through transistor P2 is greater than the current through transistor P5. For equal currents through transistor N2 and transistor P2, the gate-to-source voltage of transistor N2 must equal a voltage dV above the bias voltage B, equal to VTHH. Similarly, as INb decreases, the circuit changes state when INb goes a small voltage dV below the bias voltage B, equal to VTHL. Comparator 610 thus results with the hysteresis characteristics as illustrated in FIG. 6C. By providing transistors P5 and P6 larger than transistors P1 and P2, the circuit 610 provides no hysteresis and limited amplification. Comparator designers usually select transistors P5 and P6 about 1.1 to 1.5 times larger than transistors P1 and P2 to prevent input hysteresis and provide this limited amplification, with some loss in common mode prevention.

Referring again to FIG. 6B, since the gate-to-source voltages of transistors P2 and P5 are equal, transistors P2 and P5 form a current mirror, such that the currents through the transistors are proportional to their respective channel size. Since transistor P5 is larger than transistor P2, the transistor P5 current IP5 is larger than the transistor P2 current IP2. The unequal currents do not effectively prevent common mode operation.

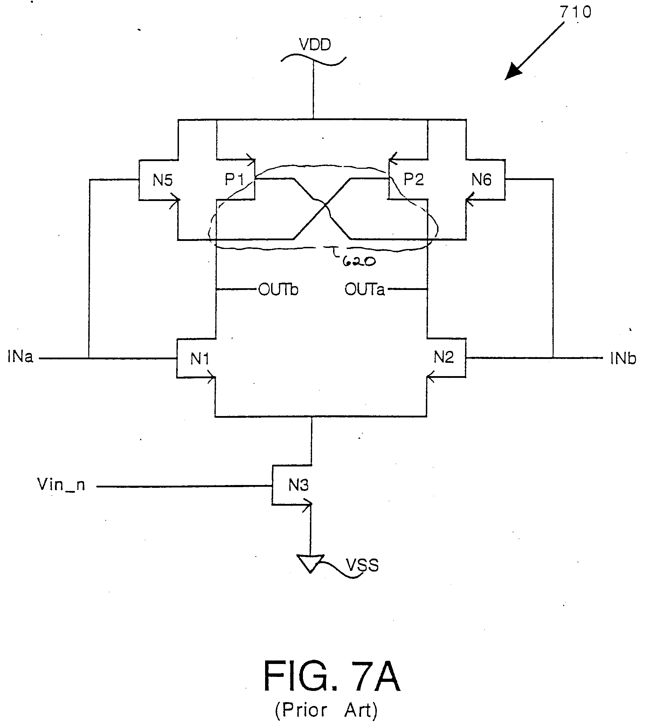

FIG. 7A illustrates still another exemplary VCDDE 710, as described in an article entitled "A 0.18µm CMOS Hot-Standby Phase-Locked Loop Using a Noise-Immune Adaptive-Gain Voltage-Controlled Oscillator," published in the proceeding of the IEEE International Solid-State Circuits Conference, February 1995, page 268. VCDDE 710 is constructed similarly to comparator 610, except that instead of diode clamps P5 and P6, NMOS transistors N5 and N6 are coupled in parallel to transistors P1 and P2 and have their gates coupled to input voltages INa and INb, respectively. As stated above with reference to FIG. 6A, cross-coupled load 620 achieves positive feedback and thus can prevent common mode oscillation.

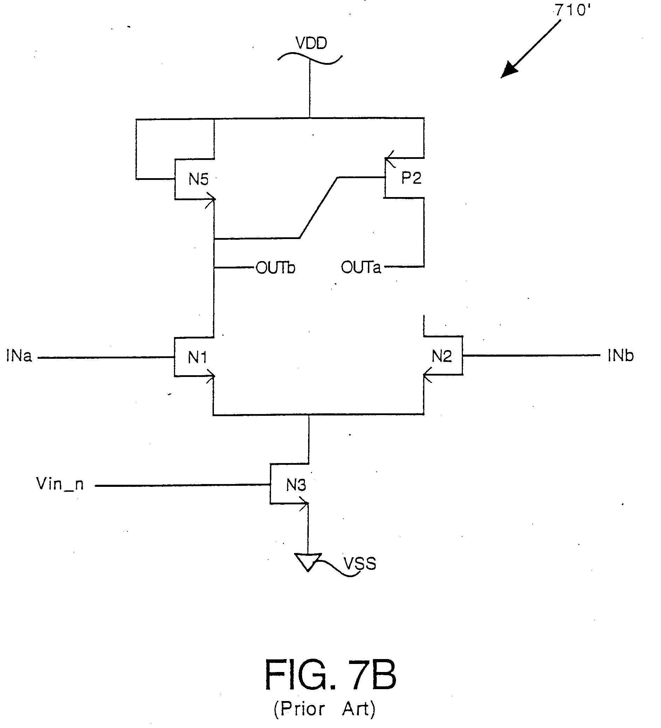

FIG. 7B illustrates a VCDDE half-circuit 710' equivalent to circuit 710 when input voltage INa is high, input voltage INb is low, output voltage OUTa is high and output voltage OUTb is low. Accordingly, transistors N2, N6 and P1 are nonconducting, and transistors N1, N3, N5 and P2 are conducting. Since the input voltage INa, which is high, is applied to the gate of transistor N5, transistor N5 is equivalent to a diode. Transistors N5 and P2 do not form a current mirror, and therefore the relation between the currents through transistors N5 and P2 depends on their sizes. However, NMOS properties and PMOS properties vary with process variation. Since circuit 710 is unsymmetrical between transistor N5 and transistor P2, the VCDDE will produce undesirable input hysteresis and undesirable common mode oscillations.

Therefore, a voltage-controlled differential delay element is needed which reliably prevents both common mode oscillation and input hysteresis at the same time.

### SUMMARY OF THE INVENTION

The present invention overcomes the limitations and deficiencies of previous systems by providing a differential delay element which prevents both common mode oscillation and input hysteresis, and methods for making and using the same. The system includes a first voltage supply terminal, a second voltage supply terminal and a current-regulating voltage terminal. The system further includes a current-control MOS transistor having its source connected to the first voltage supply terminal and its gate to the current-regulating voltage terminal. A pair of inverters are connected to the current-control MOS transistor. Each inverter has an input MOS transistor with its source connected to the drain of the current-control transistor and its gate forming a respective input terminal, and a load MOS transistor with its drain coupled to the drain of the input transistor and forming an output terminal, and its source connected to the second voltage supply terminal. The system still further includes a pair of cross-coupling means to prevent common mode oscillation, each connecting the gate of the load transistor of a respective inverter and the output terminal of the other inverter to provide positive feedback. A pair of MOS diodes are coupled to the load transistors to prevent input hysteresis characteristics. Each diode is coupled between the drain and the source of a respective load transistor. To prevent both common mode oscillation and input hysteresis, the channel sizes of the diodes substantially equal the channel sizes of the load transistors such that the diodes and the load transistors are symmetrical.

In one embodiment, the current-control transistor is a current-sourcing PMOS transistor, the load MOS transistors and the MOS diode transistors are NMOS transistors and the input MOS transistors are PMOS transistors. In an alternative embodiment, the current-control transistor is a current-sinking NMOS transistor, the load MOS transistors and the MOS diode transistors are PMOS transistors and the input MOS transistors are NMOS transistors. The MOS diodes each include a MOS transistor having its gate coupled to its drain and having a channel size equal to the channel size of the load transistors, to form a symmetrical cross-coupled load.

### BRIEF DESCRIPTION OF THE DRAWINGS

FIG. 1 is a block diagram of a phase-locked loop;
FIG. 2 is a block diagram of a FIG. 1 voltage-controlled oscillator;
FIG. 3 is a circuit diagram of a prior art voltage-controlled differential delay element;
FIG. 4 is a circuit diagram of a prior art voltage-controlled differential delay element;
FIG. 5 is a block diagram of a prior art voltage-controlled differential delay element;
FIG. 6A is a circuit diagram of a prior art comparator;
FIG. 6B is an equivalent half-circuit diagram of the FIG. 6A comparator using selected voltages;
FIG. 6C is a graphical diagram illustrating hysteresis characteristics;
FIG. 7A is a circuit diagram of a prior art voltage-controlled differential delay element;
FIG. 7B is an equivalent half-circuit diagram of the FIG. 7A voltage-controlled differential delay element using selected voltages;
FIG. 8A is a circuit diagram of a voltage-controlled differential delay element using a PMOS cross-coupled load, in accordance with the present invention;
FIG. 8B is an equivalent half-circuit diagram of the FIG. 8A voltage-controlled differential delay element, in accordance with the present invention;
FIG. 8C is a graphical diagram illustrating non-hysteresis characteristics;
FIG. 9A is a circuit diagram of a voltage-controlled differential delay element using an NMOS cross-coupled load, in accordance with the present invention;
FIG. 9B is an equivalent half-circuit diagram of the FIG. 9A voltage-controlled differential delay element, in accordance with the present invention;
FIG. 10 is a flowchart illustrating steps of a method for making a VCDDE in accordance with the present invention; and
FIG. 11 is a flowchart illustrating steps of a method for using a VCDDE in accordance with the present invention.

### DETAILED DESCRIPTION OF THE PREFERRED EMBODIMENT

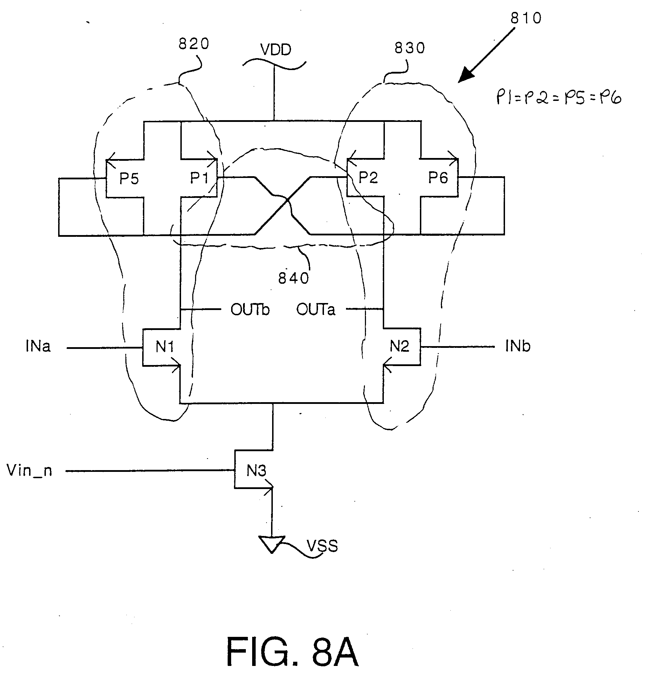

FIG. 8A is a block diagram illustrating a voltage-controlled differential delay element (VCDDE) 810 using a PMOS cross-coupled load in accordance with the present invention. VCDDE 810 includes a current-control sinking NMOS transistor N3, having its drain coupled to a ground voltage supply VSS and its gate coupled to an input current-control terminal. A voltage Vin_n is applied to the control terminal of transistor N3 for regulating the current through the transistor and thus the current through VCDDE 810, and thus the speed of the VCDDE.

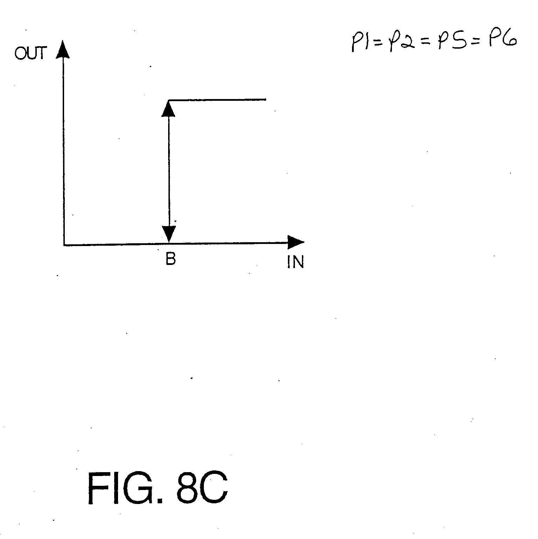

VCDDE 810 further includes a, pair of inverters 820 and 830. Inverter 820 includes an NMOS transistor N1 coupled to current-control transistor N3, and a PMOS transistor P1 coupled between NMOS transistor N1 and a voltage source VDD. Inverter 830 includes an NMOS transistor N2 coupled to current-control transistor N3, and a PMOS transistor P2 coupled between NMOS transistor N2 and voltage source VDD. Transistors N1 and N2 each have a gate terminal for receiving an input voltage, INa and INb, respectively, for regulating their currents. The gates of transistors P1 and P2 are symmetrically cross-coupled using cross-coupled load 840 to achieve positive feedback and thus to prevent common mode oscillation. Additional PMOS transistors P5 and P6, each having its gate tied to its drain to form a MOS diode, are coupled across transistors P1 and P2, respectively, for regulating current flow by forming current mirrors with transistors P1 and P2 during operations to prevent input hysteresis and common mode oscillations as described with reference to FIGs. 6A-6C and FIG. 8C.

If IP5 << IP2, then circuit 810 would have large hysteresis and no common mode oscillation. If IP5 < IP2, then circuit 810 would have hysteresis and no common mode oscillation. If IP5 = IP2, then circuit 810 would have no hysteresis and no common mode oscillation. If IP5 > IP2, then circuit 810 would have no hysteresis and some common mode oscillation. If IP5 >> IP2, then circuit 810 would have no hysteresis and high common mode oscillation. Gain is not a significant consideration for VCDDEs, as in comparator 610 design. Thus, IP5 = IP2 is the best choice, and thus it is preferred to include transistor P5 having a size equal to transistor P2 to prevent input hysteresis as illustrated in FIG. 8C. Since for differential design, transistor P1 size equals transistor P2 size, therefore transistors P1, P2, P5 and P6 are all the same size.

If VCDDE 810 enters common mode oscillation, namely, if output voltage OUTa becomes equal to output voltage OUTb, then the VCDDE will be automatically forced back into differential mode by the positive feedback of cross-coupled transistors P1 and P2. For example, if due to voltage fluctuations from noise, output voltage OUTa goes slightly lower than output voltage OUTb, then transistor P1 conducts slightly more current than transistor P2 which causes output voltage OUTb to go slightly higher. As output voltage OUTb goes slightly higher, transistor P2 conducts slightly less current, which causes output voltage OUTa to go even lower. This process repeats until output voltage OUTa becomes logical low and output voltage OUTb becomes logical high.

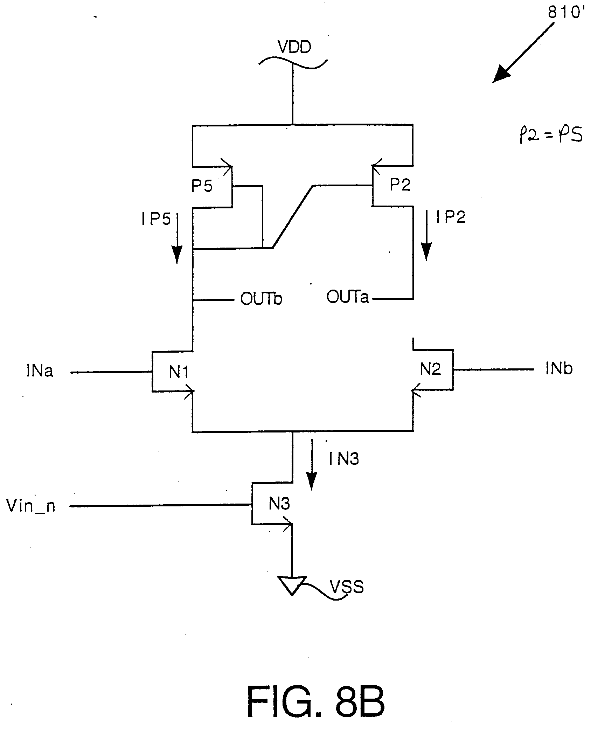

FIG. 8B illustrates a VCDDE half-circuit 810' equivalent to circuit 810 when input voltage INa is high, input voltage INb is low, output voltage OUTa is high and output voltage OUTb is low. Accordingly, transistors P1, P6 and N2 are nonconducting, and transistors P2, P5, N1 and N3 are conducting. Since transistors P2 and P5 form a current mirror, their currents are proportional to their respective channel sizes. Since gain is not a concern, the current IP5 need not be greater than the current IP2, as in comparator 610 design. Thus, to optimize the prevention of both common mode oscillation and input hysteresis, the sizes of transistors P2 and P5 must be equal to ensure that current IP5 and current IP2 are equal. Additionally, because the currents IP5 and IP2 are equal, VCDDE 810' has equal rise and fall times, which avoids the need for using clocked flip-flops to generate a system clock (not shown), thereby improving system clock speed and efficiency. Further, since the currents IP2 and IP5 each equal the current IN3, the rise and fall times can be regulated by Vin_n. Therefore, the voltage control signal Vin_n controls the speed of the VCDDE 810, and always produces equal rise time and fall time at the VCDDE outputs for each specific speed controlled by Vin_n.

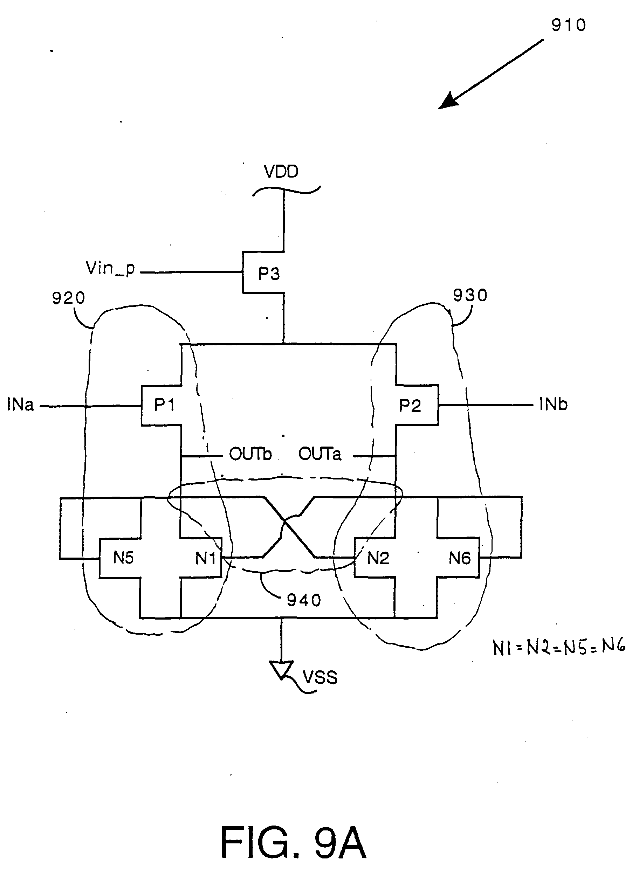

FIG. 9A is a circuit diagram of a voltage-controlled differential delay element using a NMOS cross-coupled load 940. VCDDE 910 includes a current-control sourcing PMOS transistor P3, having its drain coupled to a supply voltage source VDD and its gate coupled to an input current-control terminal. A voltage Vin_p is applied to the control terminal, for regulating the current driven through transistor P3 and thus the current through VCDDE 910, and thus for regulating the speed of VCDDE 910.

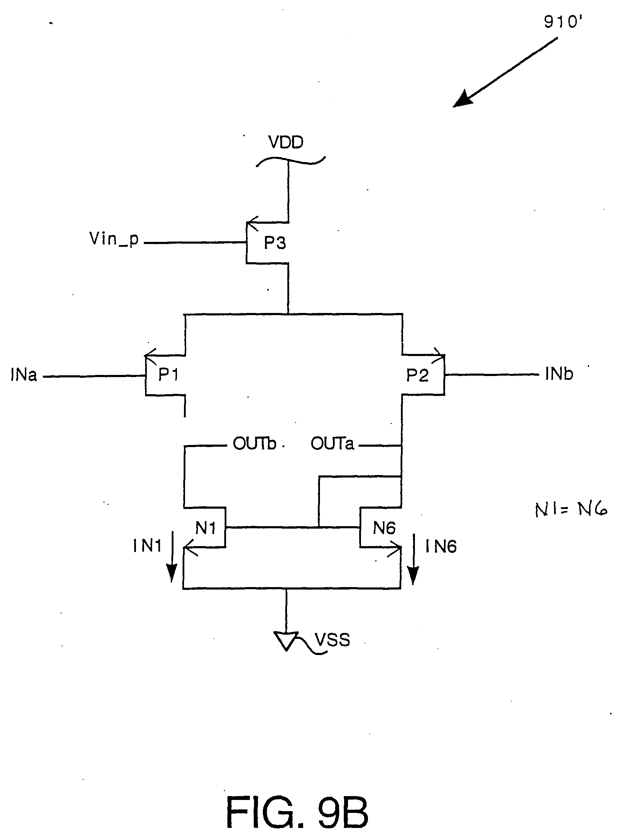

VCDDE 910 further includes a pair of inverters 920 and 930. Inverter 920 includes an NMOS transistor N1 coupled to ground voltage source VSS, and a PMOS transistor P1 coupled between NMOS transistor N1 and current-control transistor P3. Inverter 930 includes an NMOS transistor N2 coupled to ground voltage source VSS, and a PMOS transistor P2 coupled between NMOS transistor N2 and current-control transistor P3. Transistors P1 and P2 each have a gate terminal for receiving an input voltage, INa and INb, respectively, for regulating their currents. The gates of transistors N1 and N2 are symmetrically cross-coupled using cross-coupled load 940 to achieve positive feedback and thus to prevent common mode oscillation. NMOS transistors N5 and N6, each having its gate tied to its drain to form MOS diodes, are coupled across transistors N1 and N2, respectively, for regulating current flow by forming current mirrors with transistors N1 and N6 as FIG. 9B during operations to prevent input hysteresis as described with reference to FIGs. 6A-6C and FIG. 8C. For the same reasons as described with reference to FIG. 8A, transistors N1, N2, N5 and N7 are of equal size.

If VCDDE 910 enters common mode oscillation, namely, output voltage OUTa equals output voltage OUTb, then VCDDE 910 will be automatically forced back into differential mode. Using the same conditions as described in the example with reference to FIG. 8A, if output voltage OUTa goes slightly lower than output voltage OUTb, then transistor N1 conducts slightly less current, which causes output voltage OUTb to go slightly higher. As output voltage OUTb goes slightly higher, transistor N2 conducts slightly more current, which causes output voltage OUTa to go even lower. This process repeats until output voltage OUTa becomes logical low and output voltage OUTb becomes logical high.

FIG. 9B illustrates a VCDDE half-circuit 910' equivalent to circuit 910 when input voltage INa is high, input voltage INb is low, output voltage OUTa is high and output voltage OUTb is low. Accordingly, transistors N2, N5 and P1 are nonconducting, and transistors N1, N6, P2 and P3 are conducting. Since transistors N1 and N6 form a current mirror, the currents through the transistors are proportional to their respective channel sizes. Again, since gain is not a concern, the current IN6 need not be greater than the current IN1. Thus, to optimize the prevention of both common mode oscillation and input hysteresis, the sizes of transistors N1 and N6 must be equal to ensure that the current IN1 and the current IN6 are equal. Similarly, the rise and fall times of VCDDE 910 are equal, regulated by IP3 and thus Vin_p.

It will be appreciated that the output voltage OUTa/OUTb swing in the FIG. 8A PMOS VCDDE 810 is from ground voltage VSS to about ground voltage VSS plus NMOS threshold VTn, and the output voltage OUTa/OUTb swing in the FIG. 9A NMOS VCDDE 910 is from supply voltage VDD to about supply voltage VDD minus the PMOS threshold VTp. Since ground voltage VSS is less noisy and more stable than supply voltage VDD, FIG. 9A NMOS VCDDE 910 provides less jitter and thus is preferable to the FIG. 8A PMOS VCDDE 810.

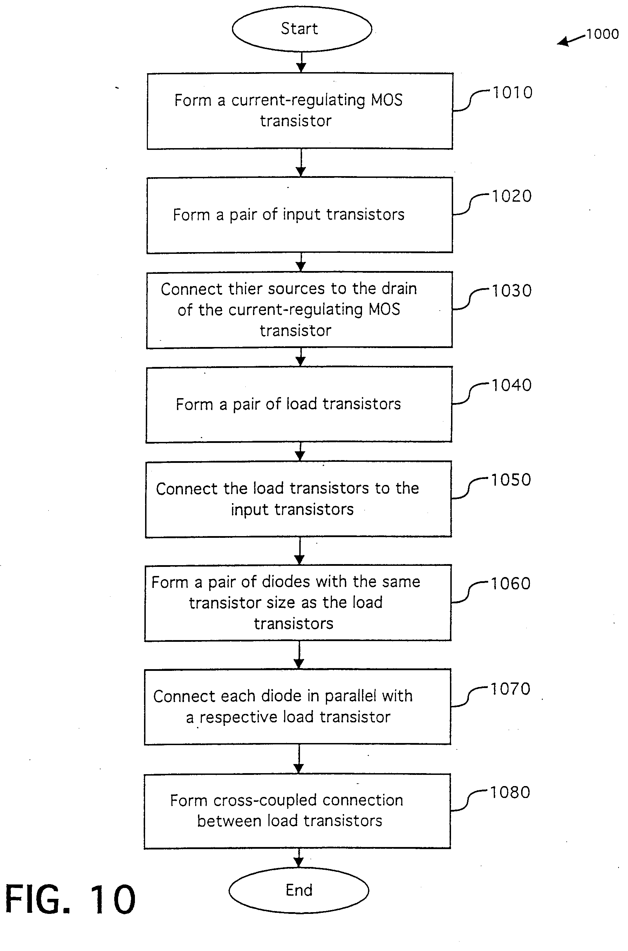

The present invention also includes a method for making and a method for using a voltage-controlled differential delay element, which is described with reference to FIGs. 8A, 8B, 9A and 9B. FIG. 10 is a flowchart illustrating steps of the preferred method 1000 for making a VCDDE 810 or a VCDDE 910, and begins in step 1010 by forming a current-regulating MOS transistor which may be either a current-sinking NMOS transistor or a current-sourcing PMOS transistor. Step 1020 forms a pair of input transistors. If the current-regulating transistor is a PMOS transistor, then the input transistors are also PMOS transistors. If the current-regulating transistor is an NMOS transistor, then the input transistors are NMOS transistors. In step 1030 the sources of the input transistors are electrically connected to the drain of the current-regulating MOS transistor.

In step 1040, a pair of load transistors each having a particular channel size are formed. If the current-regulating MOS transistor is an NMOS transistor, then the load transistors are PMOS transistors. If the current-regulating MOS transistor is a PMOS transistor, then the load transistors are NMOS transistors. In step 1050, the drains of the load transistors are electrically connected to the drains of the input transistors. In step 1060, a pair of diodes having substantially the same channel size as the load transistors are formed, and in step 1070 are each electrically connected in parallel with a respective one of the load transistors. The diodes may be formed using transistors each having its source connected to its drain. In step 1080, the gate of each load transistor is electrically connected to the drain of the other load transistor to form a cross-coupling connection. Method 1000 then ends.

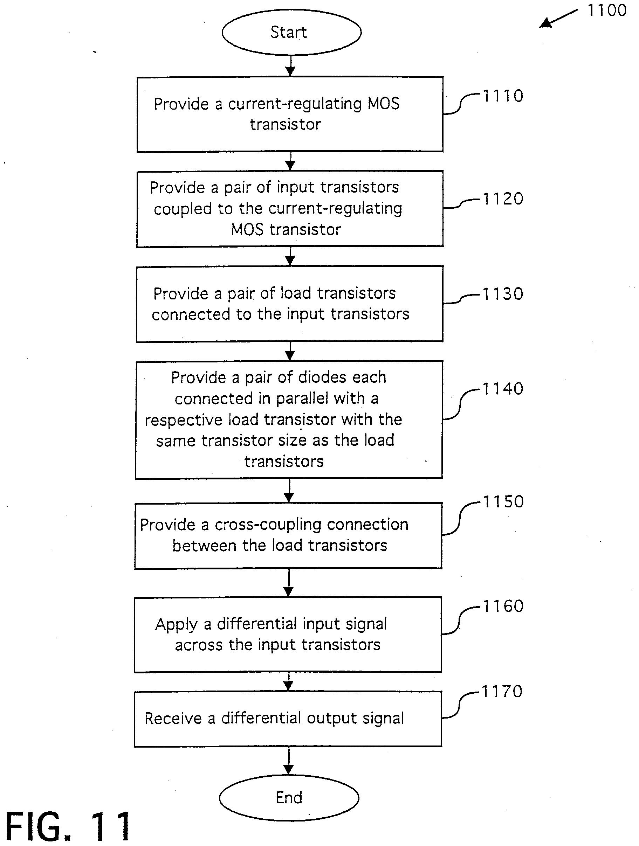

FIG. 11 is a flowchart illustrating steps of the preferred method 1100 for using a VCDDE 810 or a VCDDE 910. Method 1100 begins in step 1110 by providing a current-regulating MOS transistor, which may be either a current-sinking NMOS transistor or a current-sourcing PMOS transistor. In step 1120, a pair of input transistors are provided each having its source connected to the drain of the current-regulating MOS transistor. As stated with reference to FIG. 10, if the current-regulating transistor is a PMOS transistor, then the input transistors are also PMOS transistors. If the current-regulating transistor is an NMOS transistor, then the input transistors are NMOS transistors.

Step 1130 provides a pair of load transistors, each having its gate connected to the drain of the other transistor and each having its drain connected to a respective drain of the input transistors. Again, if the current-regulating MOS transistor is an NMOS transistor, then the load transistors are PMOS transistors. If the current-regulating MOS transistor is a PMOS transistor, then the load transistors are NMOS transistors. In step 1140, a pair of diodes with substantially the same channel size as the load transistors are provided, such that each diode is connected in parallel with a respective one of the load transistors. In step 1150, a cross-coupled connection is provided electrically coupling each gate of a load transistor to the drain of the other transistor.

In step 1160, a differential input signal is applied across the gates of the input transistors. In step 1170, a differential output signal is received across the drains of the load transistors. Because of the cross-coupled connection provided in step 1150, common mode oscillation is prevented. Because of the pair of diodes with the same transistor size as the load transistors provided in step 1140, input hysteresis characteristics are also prevented.

The foregoing description of the preferred embodiments of the invention is by way of example only, and other variations of the above-described embodiments are provided by the present invention. Although the VCDDE has been described for use in a VCO, the VCDDE can be used in other circuits. Components of this invention may be implemented using application specific integrated circuits, or using a network of interconnected conventional components and circuits. The embodiments described herein have been presented for purposes of illustration and are not intended to be exhaustive or limiting. Many variations and modifications are possible in light of the foregoing teaching. The system is limited only by the following claims.

## Claims

1. A voltage-controlled differential delay element comprising:
a pair of inverters having a pair of differential input terminals and a pair of differential output terminals, each inverter having a load transistor, a diode transistor connected in parallel to the load transistor, and an input transistor connected to the diode and to the load transistor; and
a symmetrical cross-coupling providing positive feedback between the load transistors;
wherein the diode channel sizes are substantially equal to the load transistor channel sizes.

2. The element of claim 1 further comprising a current-control switching element coupled to the input transistors.

3. The element of claim 2 wherein the current-control switching element comprises a current-sourcing PMOS transistor, each load transistor comprises a NMOS transistor, each input transistor comprises a PMOS transistor, and each diode comprises a respective transistor having its gate coupled to its drain and having a channel size equal to the channel size of the load transistors.

4. The element of claim 2 wherein the current-control switching element comprises a current-sinking NMOS transistor, each load transistor comprises a PMOS transistor, each input transistor comprises an NMOS transistor, and each diode comprises a respective transistor having its gate coupled to its drain and having a channel size equal to the channel size of the load transistors.

5. A voltage-controlled differential delay element comprising:
a current-control MOS transistor having its source connected to a first voltage supply terminal and its gate connected to a current-regulating voltage terminal;
a pair of inverters, each having
an input MOS transistor with its source connected to the drain of the current-control transistor and its gate forming a respective input terminal; and
a load MOS transistor with its drain coupled to the drain of the input transistor and forming an output terminal, and its source connected to a second voltage supply terminal;
a pair of connections each coupling the gate of the load transistor of a respective inverter to the drain of the load transistor of the other inverter; and
a pair of diodes, each coupled between the drain and the source of a respective load transistor, wherein the channel sizes of the diodes substantially equal the channel sizes of the load transistors.

6. The element of claim 5 wherein the current-control MOS transistor comprises a current-sourcing PMOS transistor, each load MOS transistor comprises an NMOS transistor each diode comprises an NMOS transistor, and each input MOS transistor comprises a PMOS transistor.

7. The element of claim 5 wherein the current-control MOS transistor comprises a current-sinking NMOS transistor, each load MOS transistor comprises a PMOS transistor, each diode comprises a PMOS transistor and each input MOS transistor comprises an NMOS transistor.

8. A voltage-controlled oscillator comprising:
at least three voltage-controlled differential delay elements, including
a current-control transistor;
a pair of inverters coupled to the current-control transistor and having a pair of differential input terminals and a pair of differential output terminals, each inverter having a load transistor and an input transistor;
a symmetrical cross-coupling providing positive feedback between the load transistors; and
a pair of diodes connected across the load transistors, wherein the channel sizes of the diodes and the channel sizes of the load transistors are substantially equal.

9. A phase-locked loop comprising:
a phase detector having a first detector input terminal for receiving an input signal, a second detector input terminal for receiving a feedback signal, and a detector output terminal;
a loop filter having an loop input terminal electrically coupled to the detector output terminal and having a loop output terminal; and
a voltage-controlled oscillator including
a current-control transistor;
a pair of inverters coupled to the current-control transistor, each inverter having a load transistor and an input transistor, the gates of the input transistors being coupled to the loop output terminal, and the drains of the input transistors being coupled to the second detector input terminal;
a symmetrical cross-coupling providing positive feedback between the load transistors; and
a pair of diodes connected across the load transistors, wherein the channel sizes of the diodes and the channel sizes of the load transistors are substantially equal.

10. A method for making a voltage-controlled differential delay element, comprising the steps of:
forming an MOS current-regulating transistor;
forming a pair of MOS input transistors;
connecting the sources of the input transistors to the drain of the current-regulating transistor;
forming a pair of MOS load transistors having the same size channels;
connecting the drains of the input transistors to the drains of the load transistors;
forming a pair of diodes each with substantially the same channel size as the load transistors and each in parallel with a respective one of the load transistors; and
connecting the gate of each load transistor to the drain of the other load transistor.

11. The method of claim 10 wherein the step of forming a current control transistor forms a current-sourcing PMOS transistor.

12. The method of claim 11 wherein the step of forming a pair of load transistors forms a pair of NMOS transistors.

13. The method of claim 11 wherein the step of forming a pair of input transistors forms a pair of PMOS transistors.

14. The method of claim 10 wherein the step of forming a current control transistor forms a current-sinking NMOS transistor.

15. The method of claim 14 wherein the step of forming a pair of load transistors forms a pair of PMOS transistors.

16. The method of claim 14 wherein the step of forming a pair of input transistors forms a pair of NMOS transistors.

17. The method of claim 10 wherein the step of forming a pair of diodes includes forming a pair of transistors, each having its gate coupled to its drain and having a channel size equal to the channel size of the load transistors.

18. A system for making a voltage-controlled differential delay element, comprising:
means for forming an MOS current-regulating transistor;
means for forming a pair of MOS input transistors;
means for connecting the sources of the input transistors to the drain of the current-regulating transistor;
means for forming a pair of MOS load transistors having the same size channels;
means for connecting the drains of the input transistors to the drains of the load transistors;
means for forming a pair of diodes each with substantially the same channel size as the load transistors and each in parallel with a respective one of the load transistors; and
means for connecting the gate of each load transistor to the drain of the other load transistor.

19. A method for using a voltage-controlled differential delay element, comprising the steps of:
providing an MOS current-regulating transistor;
providing a pair of MOS input transistors each having its source connected to the drain of the current-regulating MOS transistor.
providing a pair of MOS load transistors, each having its gate connected to the drain of the other transistor and each having its drain connected to a respective drain of the input transistors;
providing a pair of diodes with substantially the same channel size as the load transistors, each diode in parallel with a respective one of the load transistors;
applying a differential input signal across the gates of the input transistors; and
receiving a differential output signal across the drains of the load transistors.

20. A voltage-controlled differential delay element comprising:
a pair of inverters having a pair of differential input terminals and a pair of differential output terminals, each inverter having a load transistor, a diode transistor connected in parallel to the load transistor, and an input transistor connected to the diode and to the load transistor; and
a symmetrical cross-coupling providing positive feedback between the load transistors;
wherein the diode channel sizes are exactly equal to the load transistor channel sizes.
